(19) Europäisches Patentamt
European Patent Office
Office européen des brevets

(11) **EP 4 550 421 A1**

(12) **EUROPEAN PATENT APPLICATION**

(43) Date of publication:
**07.05.2025 Bulletin 2025/19**

(21) Application number: **23207036.7**

(22) Date of filing: **31.10.2023**

(51) International Patent Classification (IPC):
*H01L 29/06* (2006.01)     *H01L 29/40* (2006.01)
*H01L 29/417* (2006.01)    *H01L 29/78* (2006.01)
*H01L 29/423* (2006.01)    *H01L 23/58* (2006.01)

(52) Cooperative Patent Classification (CPC):
**H10D 30/668; H01L 23/585; H10D 30/665;
H10D 62/127; H10D 64/117; H10D 64/256;
H10D 64/519**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Nexperia B.V.**
**6534 AB Nijmegen (NL)**

(72) Inventors:
• **Patel, Hamza Hanif**
**Manchester (GB)**

• **Yogeswaran, Nivasan**
**Manchester (GB)**
• **Ghasemi, Ali**
**Manchester (GB)**
• **Gajda, Mark Andrzej**
**Manchester (GB)**

(74) Representative: **Pjanovic, Ilija**
**Nexperia B.V.**
**Legal & IP**
**Jonkerbosplein 52**
**6534 AB Nijmegen (NL)**

(54) **A SEMICONDUCTOR DEVICE AND METHOD OF FORMING A SEMICONDUCTOR DEVICE**

(57)     A semiconductor device comprising:
a first surface contact provided on a first surface of the semiconductor device;
a second surface contact provided on the first surface, physically separated from the first surface contact;
a third surface contact provided on the first surface between the first surface contact and second surface contact; and
a first trench provided in the first surface and extending into the device from the first surface, and a conductive plug provided in said trench,
wherein the trench is located in an area of the first surface between an end of the third surface contact and an edge of the first surface and wherein the first surface contact and the second surface contact overlie said first trench and the conductive plug in said first trench provides a conductive path between the first and second surface contacts.

FIG.1

EP 4 550 421 A1

## Description

### Field of the invention

Embodiments described herein generally relate to semiconductor devices and methods of forming semiconductor devices.

### Background

Semiconductor devices often comprise a plurality of identical cells to which contact needs to be made. For example, Power MOSFETs may comprise a plurality of individual MOSFETS or cells, each of which will have its own gate, source and drain. The gates may be provided within trenches and conductive plugs are provides within the trenches to make contact to the gates. The conductive plugs are then overlaid with surface contacts, which may be in the form of busbars. The conductive plug allowing a good contact to be made between the surface contact and the gate.

### Brief Description of the Drawings

The present disclosure will now be described with reference to the accompanying drawings, which are provided for aiding in explanation and understanding. The accompanying drawings should not be taken to limit the present disclosure to the specific embodiments described herein:

FIG. 1 is a schematic illustrating an arrangement of contacts for a device in accordance with an embodiment;
FIG. 2A is a schematic illustrating a cross section of a single conductive trench which may be used in a semiconductor device in accordance with an embodiment and FIG. 2B is a schematic illustrating a cross section of a pair of conductive trench separated by a moat which may be used in a semiconductor device in accordance with an embodiment;
FIG. 3 is a schematic of a contact arrangement with sealing ring which may be used with a device in accordance with an embodiment;
FIGs. 4A and 4B are example cross sections of a split-gate power MOSFET device;
FIG. 5 is an example perspective of a split-gate power MOSFET device;
FIGs. 6(a) to 6(e) are an exploded view of the device of FIG. 5 showing slices through the device of FIG. 5;
FIG. 7 is a view of an upper surface of a power MOSFET device;
FIG. 8 is a photograph showing cracks in the passivation layer of a device similar to that described with reference to FIG. 7;
FIG. 9 is a view of an upper surface of a MOSFET device in accordance with an embodiment;
FIG. 10 is a variation on the arrangements of contacts of FIG. 1 in accordance with a further embodiment;
FIG. 11 is a variation on the arrangements of contacts of FIG. 1 in accordance with a yet further embodiment;
FIG. 12 is a cross section along a conductive track in a device in accordance with an embodiment; and
FIG. 13 is a cross section across a conductive track in a device in accordance with an embodiment; and

### Detailed description

In a first aspect, a semiconductor device is provided that comprises:

a first surface contact provided on a first surface of the semiconductor device;
a second surface contact provided on the first surface, physically separated from the first surface contact;
a third surface contact provided on the first surface between the first surface contact and second surface contact; and
a first trench provided in the first surface and extending into the device from the first surface, and a conductive plug provided in said trench,
wherein the trench is located in an area of the first surface between an end of the third surface contact and an edge of the first surface and wherein the first surface contact and the second surface contact overlie said first trench and the conductor in said first trench provides a conductive path between the first and second surface contacts.

In the above, a trench or trenches are provided towards the edges of a semiconductor device which contain conductive plugs. This arrangement has many advantages.

The first trench is used to connect two surface contacts of the semiconductor device which overlie the first surface. This connection mechanism allows a physically robust connection to be provided between two surface contacts. The two surface contacts, for example, may be two aspects of the same electrode or two electrodes connected to the same voltage terminal or two regions of the same electrical terminal. Also, the connection can be formed at the same time as other fabrication steps and therefore no further fabrication steps are required to make these connections. This type of connection using the conductive plugs also allows the active area of the device to be expanded. Also, the trenches with conductive plugs prevent ion migration towards the active area of the device. The use of the sunken contacts also enhances the robustness of the device.

Trenches may be formed in other areas of the device, for example as trenches to receive gates and poly source electrodes. Thus, there are no further fabrication steps required to fabricate the first trench as it can be fabricated at the same time as other trenches. Thus, the device may further comprise at least one further trench provided to connect a gate or source within the device, the first trench and the at least one further trench extend into the device to the same depth, the at least one further trench extending under said third surface contact.

The first trench and the at least one further trench may be provided with the same conductive plug. The conductive plug in the first trench and possibly the at least one further trench is selected from one or more of W, Ti, Zr, Hf, V, Nb, Ta, Cr, Mo, Ni, Pd, Pt, Cu, Ag, Au or Zn.

In an embodiment, there will be a plurality of transistor cells, comprising a plurality of sources, gates and drains, the at least one further trench containing a source or a gate. Here, the first plurality of sources may be connected by the first surface contact and a second plurality of sources may be connected by the second surface contact. For example, the cells of the plurality of transistor cells may be split-gate transistor cells each comprising a gate, a buried first source and a second source, the first surface contact connecting the buried first sources and the second surface contact connecting the plurality of second sources which may sometimes be referred to as "moat sources".

The at least one further trench may be a plurality of further trenches, each further trench of the plurality of further trenches comprising a gate and a buried first source located in the further trench further from the first surface that the gate, wherein a contact metal is provided in the further trench to contact the gate, the third surface contact overlying the contact metal connected to the gates in the further trenches. The buried first sources may be connected to the first surface contact via conductive plugs provided in the further trenches.

In an embodiment, there is a plurality of first trenches which provide electrical connection between the first and second surface contacts.

In a further embodiment, the corners of the first, second and third surface contacts are rounded or slope at an angle of less than 90°. This assists with the prevention of cracking of passivation layers. The angle may be between 20° and 70° degrees and may be at 45°.

A sealing ring may also be provided which is the same as the conductive trenches. Thus, in further embodiments, the trench does not need to be connected to anything, but is just present fully or partially around the circumference of the active area to prevent the ingress of contaminants.

Therefore, in a further embodiment, the device further comprises a perimeter trench extending around the first, second and third surface contacts, the perimeter trench provided in the first surface and extending into the device from the first surface, the perimeter trench comprising the same conductive plug in said trench as present in the first trench.

The sealing ring does not have to be used in devices with the conductive trenches. Although, there may be some advantages to providing it in such devices as the same fabrication step is used for both. Therefore, in a second aspect, a semiconductor device is provided comprising:

a sealing ring provided in a first surface of the device, the sealing ring comprising a first trench provided in the first surface and extending into the device from the first surface, and a conductive plug provided in said trench,
the sealing ring extending around an active area in the first surface of the device.

The sealing ring may extend around the whole perimeter of the active area.

As noted above, the conductive trenches can be formed at the same time as other trenches. Therefore, in a third aspect, a method of forming a semiconductor device is provided, the method comprising:

providing a semiconductor substrate;
etching a plurality of trenches in a first surface of said substrate;
designating a first subset of the plurality of trenches and a second subset of the plurality of trenches;
providing gate electrodes in the first subset of said plurality of said trenches;
providing conductive plugs in the first and second subsets of the plurality of trenches;
providing first, second and third surface contacts on said first surface, wherein the third surface contact is provided to contact conductive plugs in trenches the first subset of said plurality of trenches, the first, second and third surface contacts being physically separated from one another on the first surface, the first and second surface contacts being provided overlying conductive plugs in the second subset of the plurality of trenches such that the first and second surface contacts are electrically connected via the conductive plugs in the second subset of the plurality of trenches.

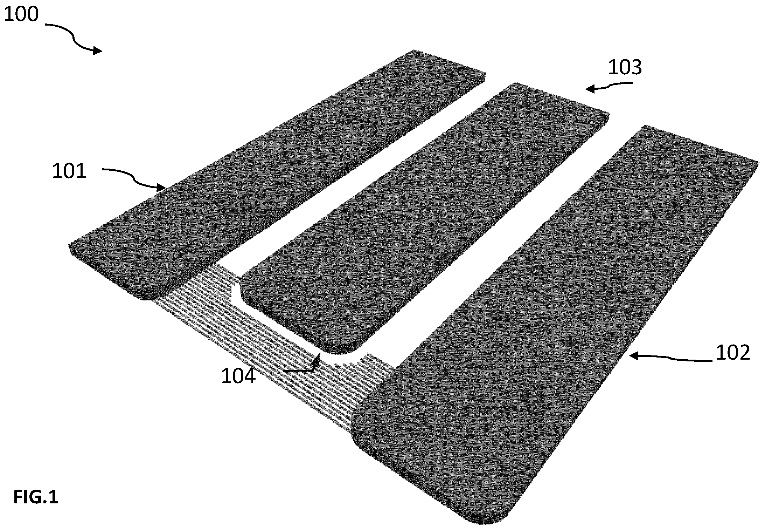

FIG. 1 is a schematic of surface contacts of a semiconductor device 100 shown in perspective. Semiconductor device can be any type of semiconductor device and of any type of material. In this specific example, the device will be referred to as a silicon device formed on a silicon substrate. However, this is used purely as an illustration.

In the simplified diagram, there is a first surface contact 101, a second surface contact 102 and a third surface contact 103.

The three surface contacts 101, 102 and 103 sit on the surface of the semiconductor device. They may be of any suitable surface contact metallisation, for example, Au, AuCu, Ag, Pd, Ni, NiCr et cetera. The first surface contact 101 and the second surface contact 102 are elongate contacts which are provided on opposing sides of the third surface contact 103. The third surface contact 103 is also an elongate contact. The first, second a third surface contacts are arranged parallel to one another and extend, in their elongate direction towards an edge of the device. The first, second and third surface contacts are physically separated from one another such that they do not touch one another.

In this example, it is desirable to electrically connect the first surface contact 101 and the second surface contact 102. However, they are arranged with the third surface contact 103 in the way.

The first surface contact 101, second surface contact 102 and third surface contact 103 are each elongate in a first direction. They are arranged in the order of the first surface contact, third surface contact followed by the second surface contact in a direction perpendicular to the first direction.

The edge of the semiconductor device is not shown in this figure. However, the first direction extends towards the edge of the semiconductor device. The first contact 101 and the second contact 102 extend such that they terminate closer to the edge of the device than the end of the third surface contact 103. In other words, the edge of the third surface contact 103 is set back slightly from the edge of the device compared to the first and second surface contacts 101 and 102.

It is desirable to connect the first and second surface contacts and to achieve this, there are a plurality of trench contacts 104 provided between the first 101 and second 102 surface contacts. The trench contacts are a plurality of trenches in the surface of the device and which are provided with conductive plugs. The first 101 and second 102 surface contacts at least partially overlie the conductive trenches and are thus electrically connected by the conductive trenches.

In FIG.1, there are a plurality of conductive trenches 104. However, there may be a single trench. In FIG. 1, the conductive trenches are shown as straight trenches which are arranged perpendicular to the first direction. However, conductive trenches 104 do not need to be straight and can be curved, zigzag or any other shape providing that they allow current to flow between the first surface contact 101 and the second surface contact 102.

Also, in FIG. 1, the plurality of conductive trenches 104 shown parallel to one another and are equi-spaced from one another. Again, although the conductive trenches 104 may be provided at regular intervals, they may also be provided in differing intervals. Also, the conductive trenches may each have the same cross-sectional profile or they may have differing cross-sectional profiles.

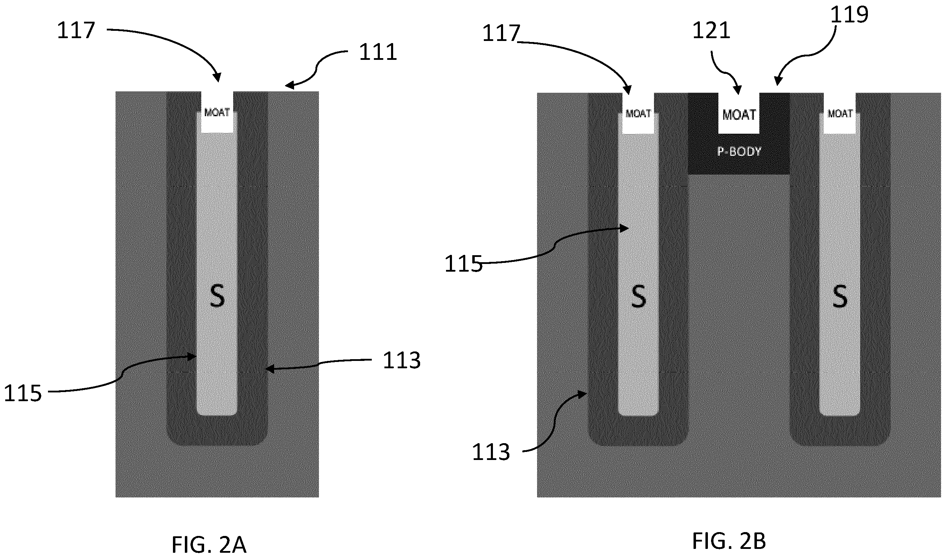

The conductive plugs in the conductive trenches allow the first surface contact 101 and the second surface contact 102 to be electrically connected. FIG. 2A shows a schematic of a cross-section of a trench. The trench 113 is formed in the surface 111 of the semiconductor and extends through the surface. The bottom part of the trench is filled with a material such as polysilicon 115. A moat for a conductive plug 117 is provided at the top of the trench 113 overlying the polysilicon 115. Region 115 (polysilicon) is insulated to the left, right and bottom. Its upper part needs to make an electrical connection to 117, so that interface is not insulated. These trenches which are used as conductive trenches are the same trenches that are used as the building blocks of a device.

FIG. 2B shows a pair of trenches of the type described with reference to FIG. 2A. To avoid any unnecessary repetition, like reference numerals will be used to denote like features. A p+ body 119 with a moat contact 121 is provided between the pair of trenches 113.

Returning to FIG. 1, the first 101 and second 102 surface contacts at least partially overlie the trenches 104. The conductive plugs of the conductive trenches directly make contact to the surface contacts 101 and 102. In an embodiment, the conductive plugs are Tungsten (W), or any one of Ti, Zr, Hf, V, Nb, Ta, Cr, Mo, Ni, Pd, Pt, Cu, Ag, Au or Zn.

Third surface contact 103 does not make contact to the conductive trenches 104. Instead, conductive material is removed around third surface contact 103 to avoid electrical connection of contact 103 to the conductive trenches 104.

As will be described later, other trenches identical to the conductive trenches 104 may be formed during the fabrication of a device which uses the contacts of FIG. 1. Therefore, no extra fabrication steps are required in order to form the conductive trenches 104. The conductive trenches 104 serve to allow electrical contact between the first 101 and second 102 surface contacts. However, the conductive trenches 104 also serve to prevent the ingress of contaminants towards the active area of the device and provide advantages both in the mechanical robustness of the device and help to allow more of the device area to be utilised.

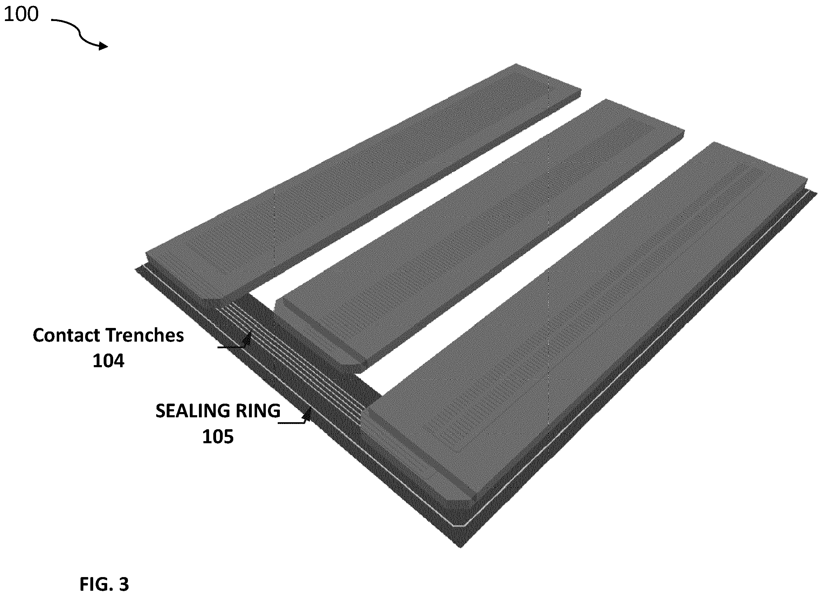

FIG. 3 shows a variation on the arrangement of FIG. 1 where a sealing ring 105 is provided around the circumference of the device. This sealing ring 105 does not serve to provide an electrical contact. However, it allows a barrier to be provided around the entire device which prevents the ingress of contaminants. The sealing ring 105 has the same cross section and composition as described for the conductive trenches of FIG. 2.

Next, a specific example of a device using the contact arrangement described with reference to FIGs. 1 to 3 will be described.

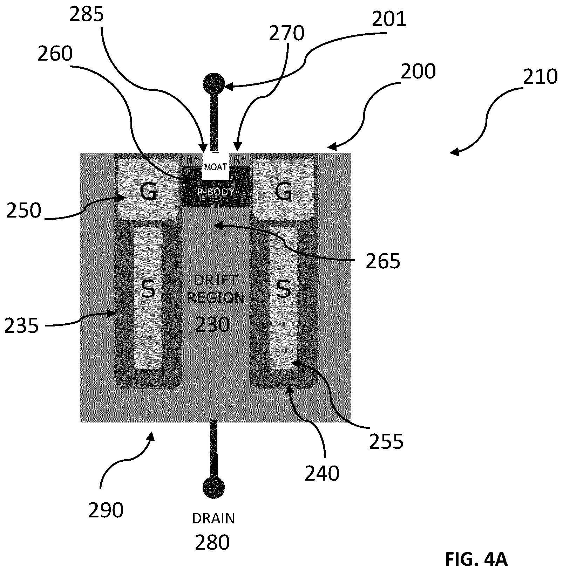

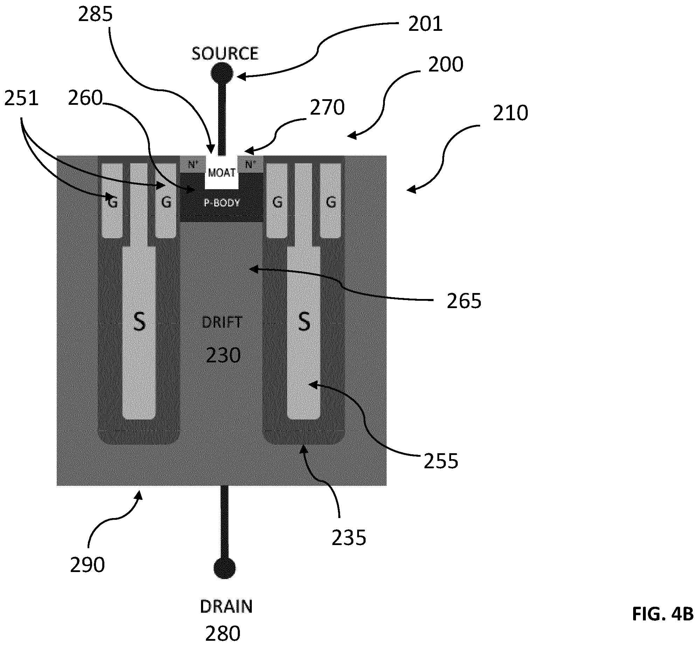

FIGs. 4A and 4B are schematics illustrating a cross section of a silicon split-gate power MOSFET devices based on the reduced surface field (RESURF). However, the device may instead be based on other semiconductor material systems, such as GaN, SiC, GaAs and/or have other types or architecture such as IGBT.

The MOSFET 210 allows current to flow from a source contact 201 to a drain contact 280, the flow of current being controlled by gates 250. In the example that will be described with reference to FIG. 4A, two gates 250 are provided in parallel trenches 235. Further, two types of source are provided. A moat source 285 is provided in the top surface between the trenches 235 and a polysilicon source 255 is provided in each trench 235 below the gate 250. The term "below" will be taken to mean that a feature that is "below" another feature is further from the top surface of the device than the other feature.

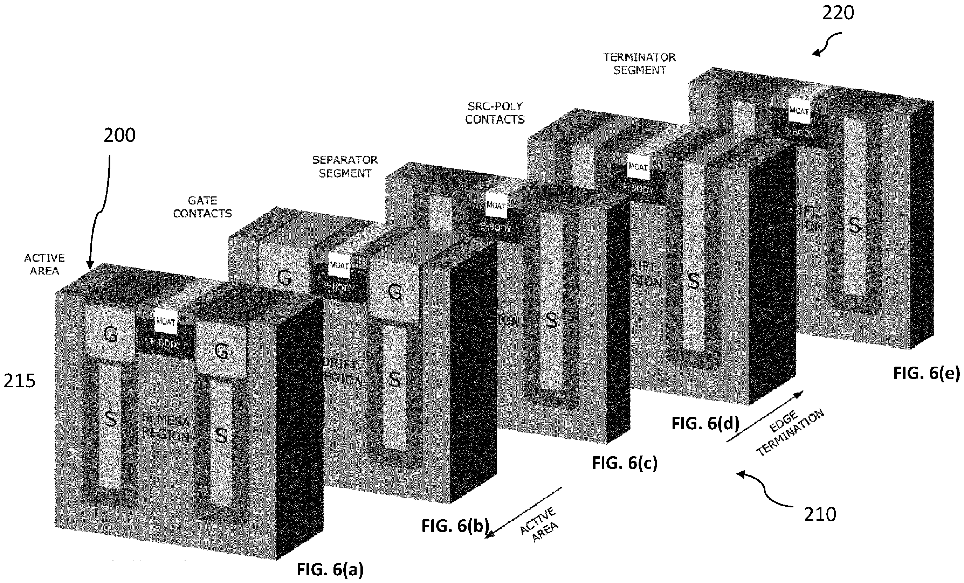

In a further embodiment, the gate can be provided as a side gate configuration 251 provided towards the top of the trench on either side of the polysilicon source as shown in FIG. 4B. In this arrangement, the polysilicon source extends between the two side gates 251 in each trench 235 towards the surface of the device. The side gates 251 are then connected in the edge termination. Edge termination of the device of FIG. 4A will described in relation to FIGs. 6(a) to 6(e).

The device 210 comprises a Si body region with an upper surface 200 and a lower surface. Two parallel trenches 235 are provided extending into the Si body region from the upper surface 200. The trenches 235 are spaced laterally from each other, and are lined with an insulating material 240 provided on the sidewalls of the trench 235. Each trench 235 has a split-gate structure, wherein an upper portion of the trench 235 includes a gate electrode 250, and a lower portion of the trench 235 includes a polysilicon source electrode 255. The gate electrode 250 and polysilicon source electrode 255 are separated by insulating material 240 provided between the electrodes.

The polysilicon source electrode 255 is also known as a trench shield. The gate electrode 250 is wider than the source polysilicon electrode 255. Accordingly, the insulation material 240 provided on the sidewalls surrounding the source polysilicon electrode 255 in the lower portion of the trench 235 has a greater thickness than the thickness of the insulation material 240 provided on the sidewalls surrounding the gate electrode 250 in the upper portion of the trench 235. Thus, the source polysilicon electrode 255 acts as a fieldplate at source potential.

A moat source is provided between the two trenches 235, the moat source comprises a recess (or moat) provided in the upper surface 200 of the Si body. The moat is filled with contact material. The contact material comprises a barrier metal layer (typically Ti + TiN) and a metal plug. Specifically, the moat 285 is lined with the barrier metal layer and the metal plug is provided over the barrier metal layer. Two n+ regions 270 are provided on either side of the moat 285. The moat extends into a p+ body region 260 formed below the moat 285.

Furthermore, a drain contact 280 is provided on the lower surface 290 of the device. A potential difference set up between source and drain contacts causes current to flow between source and drain via the drift region 230. The flow of current is controlled by the gates 250.

The challenge with a device of the type described with reference to FIG. 4 is how electrical connections are made to the various electrodes. Also, in practice, there will be many devices of the type described with reference to FIG. 4 provided on a single chip and these devices will need to be connected in parallel and in a manner that will allow connections to be made to the devices in an efficient and robust manner.

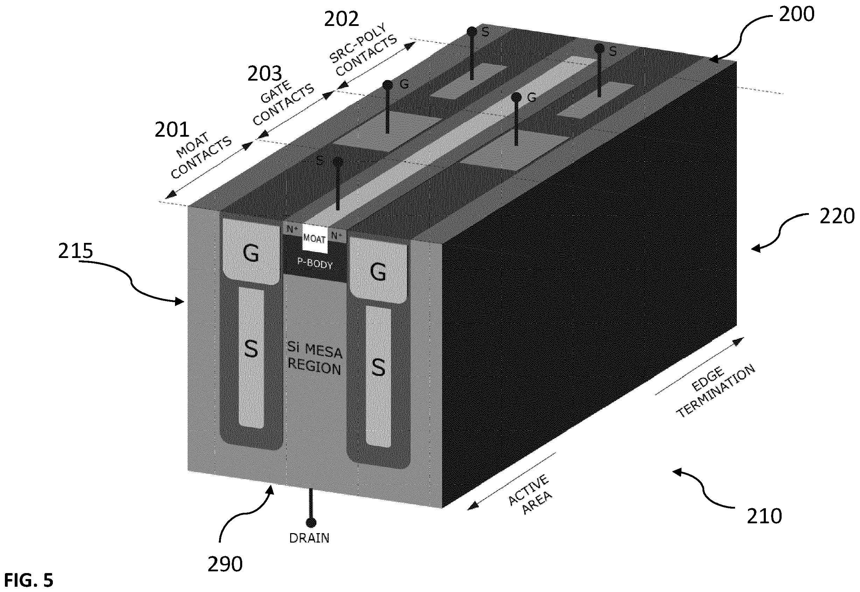

FIG. 5 shows a perspective view of the structure described with reference to FIG. 4. To avoid any unnecessary repetition, like reference numerals will be used to denote like features. FIGs 6(a) to 6(e) shows the perspective of FIG. 5 is an exploded view to more easily show the contacts.

The trenches which contain the gates are shown to extend throughout the surface of the structure and also the moat contact is also shown to extend throughout the surface of the structure.

As can be seen in the exploded view of FIG. 6(a) and FIG. 5, in region 201, insulation layer is provided overlying the gates 250 and therefore contact can be made to the moat 285 without contacting the gates 250. In section 203 of FIG. 5 (which corresponds to FIG. 6(b)) contact to the gate electrode is made. This can be seen more clearly in FIG. 6(b) with the gate metallisation is taken to the surface.

Next, on FIG. 5, it can be seen that the contact to buried source or polysilicon source contacts is brought to the surface for connection in section 202. Referring back to the exploded view of FIG. 6, the source poly contacts are shown in FIG. 6(d). To prevent shorting from the gate to the source polysilicon, a separate segment is provided as shown in FIG. 6(c) between the gate contact and the source polysilicon contacts. Finally, a terminator segment 220 is shown in Fig. 6(e) at the edge of the device.

It can be seen from FIG. 5 and FIG. 6 that the source polysilicon contacts are brought to the surface to allow connection to them towards the edge of the device. However, it is necessary to bring the gate contact to the surface before the polysilicon source (which is deeper in the device than the gate electrode). This means that the contact to the source polysilicon is separated from the moat source contact via the gate contact.

Referring back to FIG. 5, in an embodiment, there will be many devices such as those shown in FIG. 5 arranged adjacent to one another typically each device is referred to as a cell. The gate contacts of all the cells will be joined together using a gate bus bar which will extend across the region 203 of all devices. Similarly, a source polysilicon contact and a moat contact will also be extended across the cells.

As mentioned above, the device contacts may be provided as metal busbars on the surface 210. In particular, the surface 200 may have a moat source busbar, a gate busbar and a source polysilicon busbar. The source polysilicon busbar may additionally service the additional moat source contact 201 provided near the source polysilicon contacts 202. A passivation region (not shown) may be provided over the metal busbars.

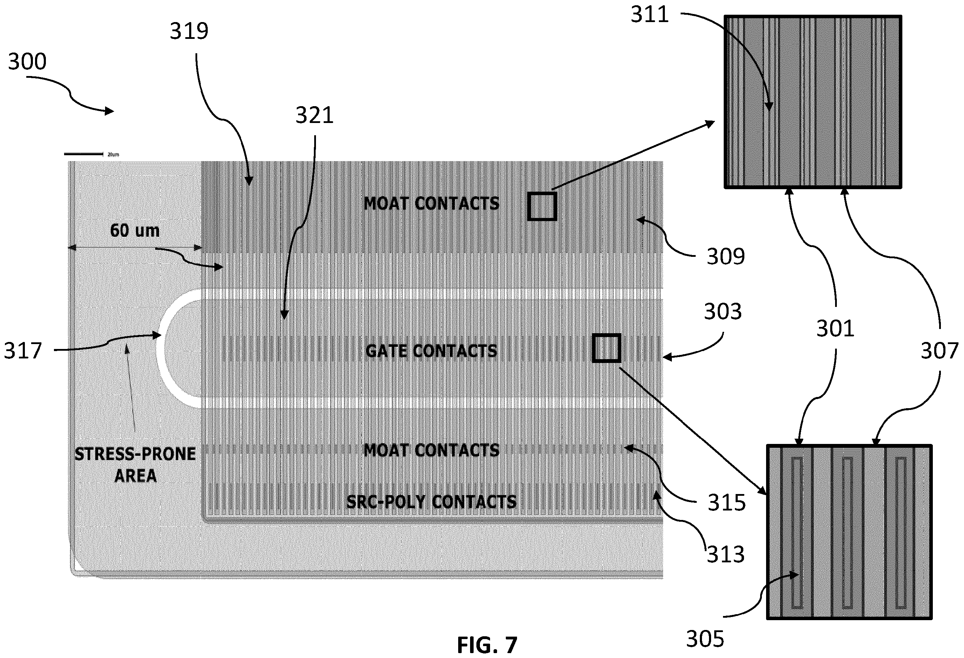

FIG. 7 shows a corner of a device comprising a plurality of transistors of the type described with reference to FIGs. 5 and 6(a) to 6(e). Two enlarged sections are shown, to show the detail of the moat contacts and the gate contacts.

In FIG. 7, there are vertical lines which extend across the right-hand corner of FIG. 7. These vertical lines denote the trenches 301 which contain gates which are shown in more detail in the two enlarged sections of FIG. 7. The trenches 301 for the gates are the same as the trenches that have been described with reference to FIGs. 5 and 6(a) to 6(e).

In area 303, a plurality of gate contacts are provided to the gates in the trenches. The gate contacts are made using conductive plugs of the type discussed with reference to FIG. 2, for example, tungsten plugs, which connect to the top of the gate. The gate contacts 305 are provided at the top of the trenches 301 which contain gates overlying and in contact with the gate.

The source moats 307 are provided between the trenches which contain gates are shown in more detail in the enlarged sections. The contacts to the moat source are found in area 309. The moat source contacts are shown as 311 in the enlarged section.

A second set of moat contacts are shown in area 315. In addition, contacts to the source polysilicon are shown in area 313. It can be seen that the contacts of the source polysilicon are shown at the edge of the device. This is due to the structure described with reference to FIGs. 5 and 6(a) to 6(e), where it is shown that the source polysilicon contact needs to be brought up to the surface towards the edge of the device such that it is separated from the moat source contacts by the gate contacts.

Comparing with FIG. 5, the moat contacts shown in area 309 correspond to the moat contact area 201 of FIG. 5, the gate contact area 303 of FIG. 7 corresponds to the gate contact region 203 of FIG. 5 and the source poly contact region 313 of FIG. 7 corresponds the source polysilicon contact region 202 of FIG. 5. It should be noted that to help with clarity of the diagrams, the second moat contact area 315 is not shown in FIG. 5. However, it will be appreciated that a second set of moat contacts could be provided to contact to the moat source in FIG. 5 between the gate contact region 203 and the source polysilicon contact region 202.

In the device described with reference to FIGs. 5 to 7, it is necessary to connect together all of the source contacts, both the source polysilicon contacts and the source moat contacts. This is done via the use of surface contact metallisation in the form of source-area metallisation 319 which extend perpendicular to the direction of the trenches 301 across the surface of the device. The gate contacts 305 in area 303 are also connected together by an elongate, gate busbar 321 which overlies each of the gate contacts. The gate metallisation busbar 321 makes contact to the gates via the conductive plugs as described above. The surface metallization layer may be formed of AlCu metal.

The gate contacts should not be connected to the source contacts. Therefore, it is necessary to isolate the gate contact busbar 321 from the source contact source-area metallisation.319 In FIG. 7, this is done by providing a gap 317 between the metallisation of the source contacts 319 and the contact metallisation of the gate contact busbar 321.

The gap 317 is shown as a U-shape layout has two main disadvantages.

(i) it creates an electrically inactive region shown on the left in FIG. 7, where there are no active trenches

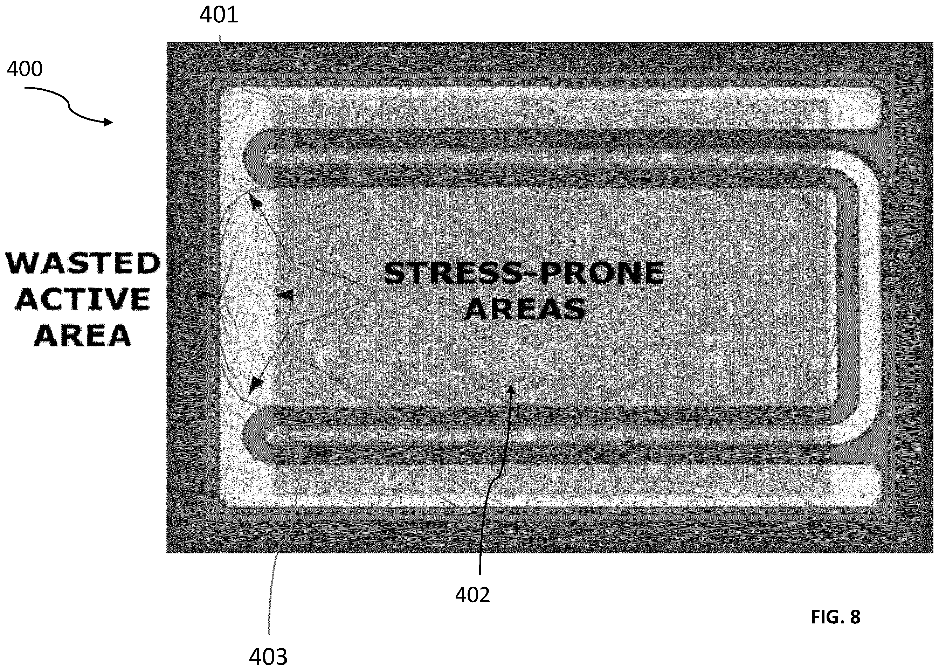

(ii) it provides a mechanical link between the two source areas through a narrow neck that is subject to a great deal of stress. This is explained with reference to FIG. 8.

FIG. 8 shows a device of the type described with reference to FIGs. 5 to 7. FIG. 7 just showed a corner of the device whereas FIG. 8 shows an entire device 400 with 2 gate busbars 401, 403 and a U-shaped gap is formed in the metallisation around both gate busbars 401, 403. A passivation layer is provided over the metallisation.

FIG. 8 shows cracks in the passivation layer resulting from thermomechanical stress, which can be transferred from region to region, reducing the lifetime of the device. The passivation layer 402 may be formed of $Si_3N_4$ or $SiO_2$. When the U-shape layout is employed, cracks will eventually appear in the passivation layer due to yielding and ratcheting occurring in the surface metallisation as the device undergoes thermomechanical cycling (TMCL). This phenomenon is even more prevalent around the stress-prone areas of FIG. 8 which lie around the curvature of the U. The thermomechanical stress induced by TMCL will be borne by all materials making up the body of the device, that is, by the $Si_3N_4/SiO_2$ passivation, AlCu power metal and the body of the MOSFET crystal. This leads to overall degradation of the semiconductor device, leading to reduced performance and eventual failure of the device.

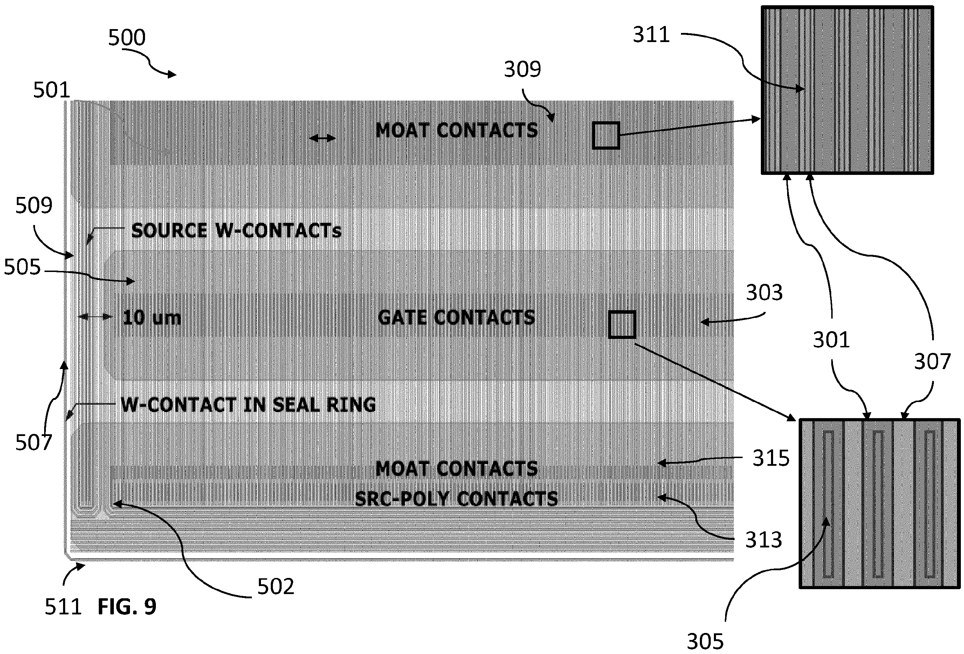

FIG. 9 is a plan view of the top surface 500 of a semiconductor device in accordance with an embodiment. The metallisation shown in FIG. 9, is different to that of FIG. 7. However, the active area of the underlying device is the same and therefore, like reference numerals are used to denote like features.

The surface metallisation of FIG. 9 results in 3 distinct surface contact areas: gate busbar 505, moat source-area metallisation 501 and polysilicon source -area metallisation 502. Polysilicon source-area metallisation 502connects to the polysilicon source electrodes which are below the gates in the trenches. As explained with reference to FIG. 7, a second set of moat source contacts 315 are also provided on the same side of the gate busbar 505 which allows a single -source-area metallisation to cover both moat contacts 315 and source poly contacts 313.

The gate busbar 505, moat source-area metallisation 501 and poly silicon source-area metallisation 502 are each elongate areas and arranged parallel to one another. The moat source-area metallisation 501 and the polysilicon source-area metallisation 502 extend closer towards edge 507 than the gate busbar 505. In other words, the gate busbar 505 is set back slightly from the edge 507 compared to the moat source-area metallisation 501 and the polysilicon source-area metallisation 502.

As explained with reference to FIG. 7, it is necessary to electrically connect to the moat source-area metallisation 501 and the polysilicon source-area metallisation 502. In FIG. 7, this was achieved by a layer of surface metallisation that overlies the edge region of the gate source busbar 505. However, in the example of FIG. 9, the moat source-area metallisation 501 the polysilicon source-area metallisation 502 are connected using trenches with conductive plugs 509.

The trenches are of the type described with reference to FIGs. 1 and 2. Here, a conductive plug is provided in the top of the trench. Below the conductive plug is polysilicon which, in this case, just serves to prevent contamination from entering the trench and support for the conductive plug. The conductive plug itself provides the transmission of current and voltage between the moat source-area metallisation 501 the polysilicon source-area metallisation 502. There may be a plurality of conductive trenches 509 between the moat source-area metallisation 501 and the polysilicon source-area metallisation.

It will be noted, that the moat source-area metallisation 501 and the polysilicon source-area metallisation 502 are also electrically connected via some of the polysilicon sources which run underneath the gate busbar 505. This is because both moat source busbar 501 and polysilicon source busbar 502 cover moat contacts. However, the source polysilicon in the trenches is relatively high resistance, therefore, the source polysilicon does not form an electrically efficient conductive path to couple regions 501 and 502.

In addition to the use of the conductive trenches 509 to connect the moat source-area metallisation 501 and the polysilicon source-area metallisation 502, a sealing ring 511 is provided around the outside of the device which has the same configuration as the conductive trenches and serves to prevent the ingress of contaminants into the active area of the device.

The conductive tracks 509 may have identical depth from the upper surface into the semiconductor device.

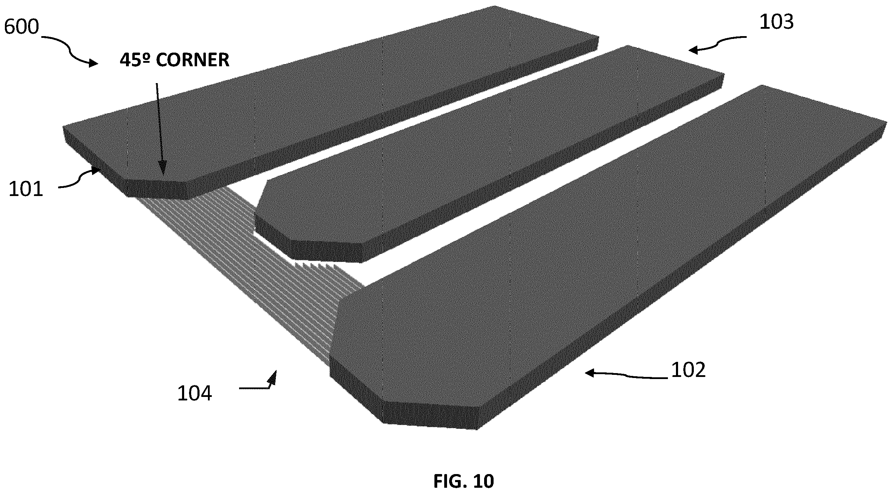

FIG. 10 shows a variation on the design of the surface contacts of FIG. 1. To avoid any unnecessary repetition, like reference numerals will be used to denote like features with those of FIG. 1. The first surface contact 101 corresponds to the moat contact busbar in FIG. 9, the second surface contact 102 corresponds to the polysilicon busbar of FIG. 9 and the third surface contact to the gate busbar of FIG. 9.

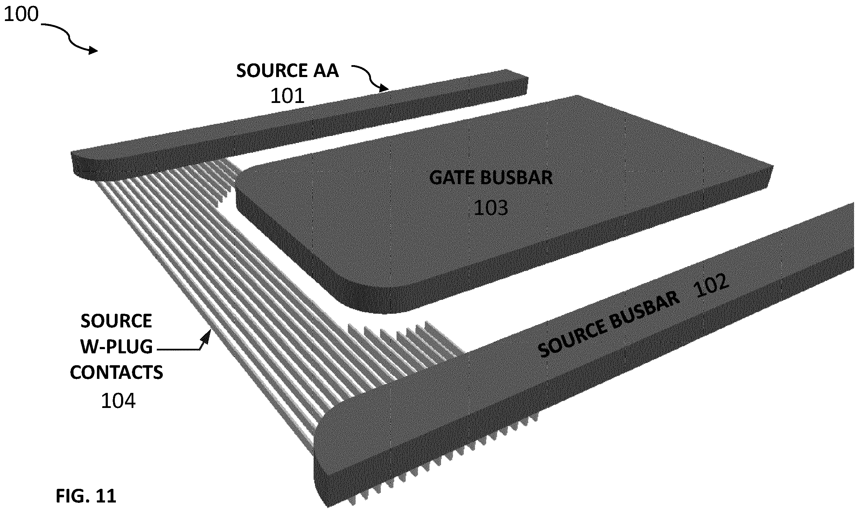

The corners of first, second and third surface contacts are modified in FIG. 10. Instead 90° corners, the corners are "cut off" so that they are flattened by a plane at 45°. This, configuration is more robust against cracking. In a further variation, as shown in FIG. 11, the corners are rounded to provide a larger radius of curvature over a 90° corner.

In FIG. 10, a 45° corner is shown. However, it will be appreciated that other angles could be used, for example from 20° to 70°. Instead, there is a requirement for the corner to be made less sharp than that of a 90° corner.

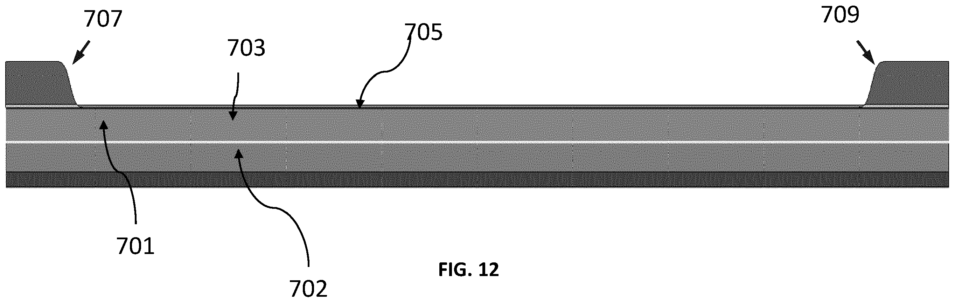

FIG. 12 is a schematic illustrating a cross-section of one of the conductive trenches of FIG. 9. In FIG 12, the cross section is taken along the length of a conductive trench 509. The conductive trench 701 extends down to line 702. The conductive trench 701 is filled with poly silicon 703. On top of the polysilicon, a conductive plug 705 is provided. In FIG. 12, since the crossing section is taken along the length of the trench the polysilicon is present across the whole cross-section.

The first surface contact 707 overlies the conductive trench at one end and the second surface contact 709 overlies the conductive trench of the second opposing end. Thus, the conductive trench electrically connects the first and second surface contacts.

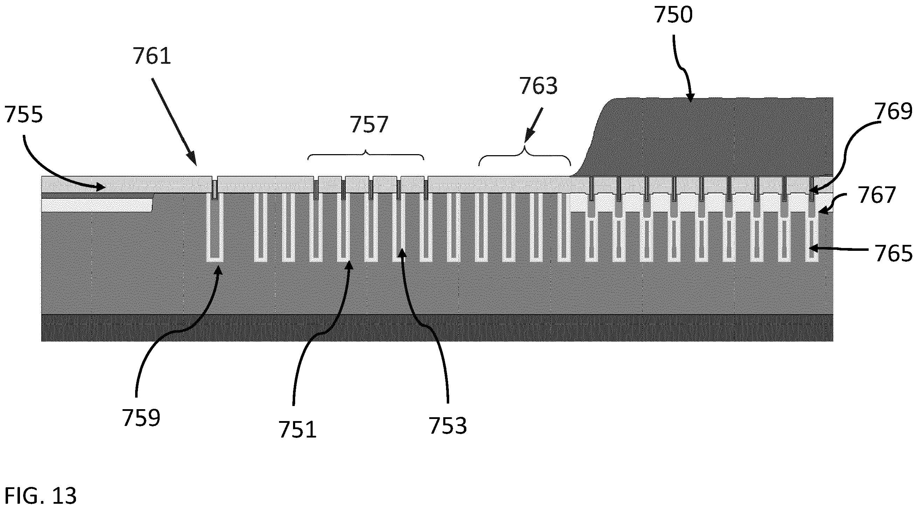

FIG. 13 shows a cross-section taken through the device of FIG. 9 extending from the edge of the device 507 of FIG. 9 through the gate contacts (area 303 of FIG. 9). The cross-section shows a plurality of trenches 751. These trenches are all formed to the same depth. The trenches shown in FIG. 13 are used for different purposes. Each trench 751 is filled with polysilicon 753 and an insulator may be provided around the polysilicon. For the trenches which are to form the conductive trenches which connect the first surface contact and the second surface contact, conductive plugs 757 are provided above the polysilicon 753. It is one of these conductive trenches which is shown in cross-section in FIG. 12.

Trench 759 forms a sealing ring. This trench is formed towards the edge of the device. This is the outermost trench 759 and is also formed in the same manner as the conductive trenches with a polysilicon filler and a conductive plug 761 provided overlying the polysilicon filler. Again, the conductive plug serves to prevent the ingress of contaminants. In addition, the conductive trenches also provide some defence against the ingress of contaminants and this is a further advantage of the provision of the conductive trenches.

Gate contact 750 is shown overlying the gate structure. Here, trenches which contact gates are formed which are again identical in depth to the trenches 751 which are used to also form the conductive trenches. Thus, the trenches for the gates and conductive trenches may all be etched in the same fabrication step. Polysilicon 765 is provided in the trenches.

This will then form the polysilicon sources which is surrounded with an insulating material. Above the insulative material, gate metal 767 is provided. Above the gate metal, in the regions where contact the gate 767 is required, conductive plugs 769 are also provided. It can be seen that these conductive plugs 769 then directly contact to gate metal 750.

In an embodiment, other trenches are also formed for ease of fabrication and these trenches are just filled with polysilicon and are shown as trenches 763. These trenches are filled a polysilicon to prevent from contaminants entering the trench.

The trenches may be etched to a depth range of 1 to 20 microns. An example of possible etch chemistries are: $SFs + O_2$; $C_4F_8$; HBr + He or $Cl_2$

It can be seen that the above system provides a simplified fabrication. All of the trenches can be etched together in the same step. Further, polysilicon can be provided to all of the trenches in the same step. Further fabrication steps are then performed on the trenches which will contain gates to allow the gate metal to be provided above the polysilicon. Then, in the trenches to which conductive plugs are provided, the same fabrication step can be used to provide conductive plugs to all trenches where conductive plugs are required.

The conductive plug may be formed of Tungsten (W). In other examples, the plug may be formed of any one of Ti, Zr, Hf, V, Nb, Ta, Cr, Mo, Ni, Pd, Pt, Cu, Ag, Au or Zn, or a combination thereof.

The material of the plugs is robust to etching techniques such as dry etching and wet etching techniques which use etchants such as AlCu-etch acid ($H_3PO_4$/$HNO_3$, 50 °C) and can still provide a conduction path after the conductive plugs have been exposed to subsequent processing steps. Tungsten plugs have been found to be particularly robust to further processing.

The provision of an electrical connection between two source regions using the conductive trenches avoids the need of a surface connection such as AlCu power metal to connect the source contacts provides a robust electrical nexus without creating topography.

By using this method of connecting the two source regions the active area of the chip may be extended. For example, the width of the metallisation which connects the two source contacts in FIG. 7 may be 60 $\mu$m, which creates 60 $\mu$m inactive area. However, using the arrangement of FIG. 9 where the source contacts are connected via conductive trenches, the conductive trenches need a much smaller area, for example 10 $\mu$m which allows the width of the inactive area to be reduced by 50 $\mu$m and can be converted to active area. Additionally, by making the U-shape redundant, physical separation of the two source regions is achieved, which benefits mechanical robustness as explained below.

Further, the incorporation of a moat contact filled with tungsten in the seal ring of the device, without the use of AlCu. The exclusion of AlCu makes the seal ring ultra compact without sacrificing its ion-stopping primary functionality.

Using the W-plug connectors and the decoupled-source layout, approximately 50um of active area can be recovered on the left side of the chip, allowing this area to be converted to active area achieving the active-area increase tabulated in Table 1 for max die in popular power packages.

*Table 1 Gain in active area when a 50um active-area strip is added*

| Package footprint | % Gain |
|---|---|
| 12 x 12 mm | 0.6% |
| 8 x 8 mm | 0.8% |
| 5 x 6 mm | 1.4% |
| 3 x 3 mm | 4.0% |

The decoupling of the two source metals allows a redesign of the source-metal corner to provide either a larger radius of curvature or the 45° layout in extreme corners, which is more robust against cracking of passivation layers.

The addition of an ultra-compact seal ring made entirely of a W-plug maximises the use of silicon real-estate while providing a robust ion-ingress barrier. The use of a moated contact in a source-trench around the entire periphery of the device is superior to using just a source-trench by itself because the moated contact cuts off the primary ion-migration path, which is through the inter-layer dielectric dielectric.

In the above arrangements, the conductive plug is fully retracted into the trench and its effective surface thickness, $t_m$, is extremely low, effectively close to zero thickness. This enhances the thermomechanical figure of merit (FOM), S, of the source contacts made using conductive plugs in line with equations (1) and (2):

$$S = \frac{E_M(\alpha_M - \alpha_{Si}).\Delta T}{(1-\nu_M)\sqrt{\sigma_M^2 - 3\tau_M^2}} \qquad (1)$$

Based on stress theory, the parameter S in equation (1) is an indicator of the thermomechanical stability critical for controlling the initiation of crack formation during thermal cycling of the device. For as long as S < 2, no yielding and ratcheting of AlCu will occur during TMCL and the thermomechanical stress induced by TMCL will be borne by all materials making up the body of the device, that is, by a passivation layer, AlCu power metal and the body of the MOSFET crystal. Making the quantity $\sigma_M$ large is therefore desirable.

The FOM quantity, S, can be optimised by careful engineering approaches such as the yield strength, $\sigma_M$, improvement of the metal layer. Enhancement of yield strength, $\sigma_M$, can be attained by:

(i) reducing the material thickness, $t_m$, as shown in equation (2)

(ii) appropriate choice of materials with higher intrinsic yield strength

$$\sigma_M = \frac{F}{w_m t_m} \qquad\qquad (2)$$

This embodiment proposes an approach that attains an improved yield strength, $\sigma_M$, of the source-to-source nexus by employing both of the aforementioned techniques.

The use of an extremely thin tungsten layer as a source-to-source connector results in an improvement in the yield strength of the nexus, especially when deployed in regions that are prone to high thermomechanical stress during TMCL. The use of tungsten instead of AlCu increases Young's modulus of the nexus ~6 times. Thus, the above embodiments result in a significant improvement in yield strength of the connecting material using a viable method compatible with the existing manufacturing technology.

The above examples have predominantly concerned a silicon split gate MOSFET. However, the above principles can be applied to any device where it is necessary to make an electrical connection between two surface contacts.

Also, the above seal ring can be used for any semiconductor device. It can be used in combination with the conductive trenches or it can be used completely on its own in a device which does not use the above described conductive trenches.

Although the disclosure has been described in terms of preferred embodiments as set forth above, it should be understood that these embodiments are illustrative only and that the claims are not limited to those embodiments. Those skilled in the art will be able to make modifications and alternatives in view of the disclosure which are contemplated as falling within the scope of the appended claims. Each feature disclosed or illustrated in the present specification may be incorporated in the disclosure, whether alone or in any appropriate combination with any other feature disclosed or illustrated herein.

Many other effective alternatives will occur to the person skilled in the art. It will be understood that the disclosure is not limited to the described embodiments, but encompasses all the modifications which fall within the scope of the appended claims.

**Claims**

**1.** A semiconductor device comprising:

a first surface contact provided on a first surface of the semiconductor device;
a second surface contact provided on the first surface, physically separated from the first surface contact;
a third surface contact provided on the first surface between the first surface contact and second surface contact; and
a first trench provided in the first surface and extending into the device from the first surface, and a conductive plug provided in said trench,
wherein the trench is located in an area of the first surface between an end of the third surface contact and an edge of the first surface and wherein the first surface contact and the second surface contact overlie said first trench and the conductive plug in said first trench provides a conductive path between the first and second surface contacts.

**2.** A semiconductor device according to claim 1,
the device further comprising at least one further trench containing a gate or source within the device, the first trench and the at least one further trench extend into the device to the same depth, the at least one further trench extending under said third surface contact.

**3.** A semiconductor device according to claim 2, wherein the first trench and the at least one further trench are provided with the same conductive plug.

4. A semiconductor device according to any preceding claim, wherein the semiconductor device is a plurality of transistor cells comprising a plurality of sources, gates and drains, the at least one further trench providing electrical connection to a source or a gate.

5. A semiconductor device according to claim 4, wherein a first plurality of sources are connected by the first surface contact and a second plurality of sources are connected by the second surface contact.

6. A semiconductor according to claim 5, wherein the cells of the plurality of transistor cells are split-gate transistor cells each comprising a gate, a buried first source and a second source, the first surface contact connecting the buried first sources and the second surface contact connecting the plurality of second sources.

7. A semiconductor device according to claim 6, wherein the at least one further trench is a plurality of further trenches, each further trench of the plurality of further trenches comprising a gate and a buried first source located in the further trench further from the first surface that the gate, wherein a contact metal is provided in the further trench to contact the gate, the third surface contact overlying the contact metal connected to the gates in the further trenches.

8. A semiconductor device according to claim 7, wherein the buried first sources are connected to the first surface contact via conductive plugs provided in the plurality of further trenches.

9. A semiconductor device according to any preceding claim, wherein the conductive plug in the first trench and the at least one further trench is selected from one or more of W, Ti, Zr, Hf, V, Nb, Ta, Cr, Mo, Ni, Pd, Pt, Cu, Ag, Au or Zn.

10. A semiconductor device according to any preceding claim, wherein a plurality of first trenches provide electrical connection between the first and second surface contacts.

11. A semiconductor device according to any preceding claim, further comprising a perimeter trench extending around the first, second and third surface contacts, the perimeter trench provided in the first surface and extending into the device from the first surface, the perimeter trench comprising the same conductive plug in said trench as present in the first trench.

12. A semiconductor device according to any preceding claim, wherein the corners of the first, second and third surface contacts are rounded or slope at an angle of less than 90°.

13. A semiconductor device comprising:

a sealing ring provided in a first surface of the device, the sealing ring comprising a first trench provided in the first surface and extending into the device from the first surface, and a conductive plug provided in said trench, the sealing ring extending around an active area in the first surface of the device.

14. A semiconductor device, wherein the sealing ring extends around the whole perimeter of the active area.

15. A method of forming a semiconductor device, the method comprising:

providing a semiconductor substrate;
etching a plurality of trenches in a first surface of said substrate;
designating a first subset of the plurality of trenches and a second subset of the plurality of trenches;
providing gate electrodes in the first subset of said plurality of said trenches;
providing conductive plugs in the first and second subsets of the plurality of trenches;
providing first, second and third surface contacts on said first surface, wherein the third surface contact is provided to contact conductive plugs in trenches the first subset of said plurality of trenches, the first, second and third surface contacts being physically separated from one another on the first surface, the first and second surface contacts being provided overlying conductive plugs in the second subset of the plurality of trenches such that the first and second surface contacts are electrically connected via the conductive plugs in the second subset of the plurality of trenches.

FIG.1

FIG. 2A

FIG. 2B

Contact Trenches
104

SEALING RING
105

100

FIG. 3

FIG. 4A

EP 4 550 421 A1

FIG. 4B

FIG. 5

FIG. 6(a)

FIG. 6(b)

FIG. 6(c)

FIG. 6(d)

FIG. 6(e)

EP 4 550 421 A1

FIG. 7

EP 4 550 421 A1

EP 4 550 421 A1

FIG. 8

**FIG. 9**

**FIG. 10**

EP 4 550 421 A1

SOURCE AA
101

GATE BUSBAR
103

SOURCE
W-PLUG
CONTACTS
104

SOURCE BUSBAR 102

100

FIG. 11

FIG. 12

FIG. 13

EP 4 550 421 A1

**Europäisches Patentamt**
**European Patent Office**
**Office européen des brevets**

# EUROPEAN SEARCH REPORT

Application Number

EP 23 20 7036

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/393004 A1 (SAXENA TANUJ [US] ET AL) 8 December 2022 (2022-12-08) | 1-10,15 | INV. H01L29/06 |
| Y | * paragraphs [0018] - [0064]; figures 1-11 * | 11,12 | H01L29/40 H01L29/417 |
| | ----- | | H01L29/78 |
| Y | WO 2022/210033 A1 (ROHM CO LTD [JP]) 6 October 2022 (2022-10-06) | 11 | H01L29/423 H01L23/58 |
| A | * figures 10-32 * & US 2024/014812 A1 (FUKUDA YOSHINORI [JP] ET AL) 11 January 2024 (2024-01-11) * paragraphs [0148] - [0452] * | 1-10,15 | |
| | ----- | | |
| Y | JP 2022 177294 A (RYUKA) 30 November 2022 (2022-11-30) * paragraphs [0178] - [0183]; figure 28 * | 12 | |
| | ----- | | |
| X | US 2020/357755 A1 (SHIBIB M AYMAN [US] ET AL) 12 November 2020 (2020-11-12) * paragraphs [0001] - [0046]; figures 1-5 * | 13,14 | |
| | ----- | | TECHNICAL FIELDS SEARCHED (IPC) |
| X | US 8 664 714 B2 (LIU CHU-KUANG [TW]; EXCELLIANCE MOS CORP [TW]) 4 March 2014 (2014-03-04) * column 4, line 17 - column 6, line 40; figures 2-9 * | 13,14 | H01L |
| | ----- | | |

The present search report has been drawn up for all claims

| Place of search | Date of completion of the search | Examiner |
|---|---|---|
| Munich | 1 August 2024 | Götz, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| Europäisches Patentamt European Patent Office Office européen des brevets | **Application Number** |
|---|---|
| | EP 23 20 7036 |

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

| Europäisches Patentamt<br>European Patent Office<br>Office européen des brevets | **LACK OF UNITY OF INVENTION**<br>**SHEET B** | **Application Number**<br>EP 23 20 7036 |
|---|---|---|

The Search Division considers that the present European patent application does not comply with the requirements of unity of invention and relates to several inventions or groups of inventions, namely:

      1. claims: 1-12, 15

            Conductive plug in trench providing a conductive path; corresponding method
                      - - -

      2. claims: 13, 14

            Sealing ring
                      - - -

## ANNEX TO THE EUROPEAN SEARCH REPORT
## ON EUROPEAN PATENT APPLICATION NO.

EP 23 20 7036

This annex lists the patent family members relating to the patent documents cited in the above-mentioned European search report.
The members are as contained in the European Patent Office EDP file on
The European Patent Office is in no way liable for these particulars which are merely given for the purpose of information.

01-08-2024

| Patent document cited in search report | | | Publication date | Patent family member(s) | | | Publication date |
|---|---|---|---|---|---|---|---|
| US 2022393004 | A1 | | 08-12-2022 | EP | 4099392 | A1 | 07-12-2022 |
| | | | | US | 2022393004 | A1 | 08-12-2022 |
| WO 2022210033 | A1 | | 06-10-2022 | JP WO2022210033 | | A1 | 06-10-2022 |
| | | | | US | 2024014812 | A1 | 11-01-2024 |
| | | | | WO | 2022210033 | A1 | 06-10-2022 |
| JP 2022177294 | A | | 30-11-2022 | CN | 108987386 | A | 11-12-2018 |
| | | | | JP | 7396425 | B2 | 12-12-2023 |
| | | | | JP | 2022177294 | A | 30-11-2022 |
| | | | | US | 2018350960 | A1 | 06-12-2018 |
| US 2020357755 | A1 | | 12-11-2020 | NONE | | | |
| US 8664714 | B2 | | 04-03-2014 | CN | 202633320 | U | 26-12-2012 |
| | | | | TW | M435722 | U | 11-08-2012 |
| | | | | US | 2013248986 | A1 | 26-09-2013 |

EPO FORM P0459

For more details about this annex : see Official Journal of the European Patent Office, No. 12/82